# EUROPEAN PATENT APPLICATION

(11) **EP 4 542 860 A1**
(43) Date of publication of application: **23.04.2025**
(21) Application number: 24152688.8
(22) Date of filing: 18.01.2024
(51) Int. Cl.: H03K 17/30

(54) **IDEAL DIODE CIRCUIT**

(30) Priority: 20.10.2023 CN 202311368336
(71) Applicant: Suzhou Watech Electronics Co., Ltd., Suzhou, Jiangsu 215125 (CN)
(72) Inventor: WANG, Rong, Suzhou, 215125 (CN); DING, Shixuan, Suzhou, 215125 (CN)
(74) Representative: dompatent von Kreisler Selting Werner - Partnerschaft von Patent- und Rechtsanwälten mbB

(57) **Abstract**

An ideal diode circuit comprises a capacitor unit and a transistor unit electrically connected thereto, a voltage conversion unit electrically connected to the capacitor unit and the transistor unit respectively and configured to charge the capacitor unit via a parasitic diode in the transistor unit, a control unit, whose the input end electrically connected to the capacitor unit, whose the output end electrically connected to the control end of the transistor unit, configured to output a first driving signal or a second driving signal based on the voltage signal of the capacitor unit, drive the transistor unit to turn off under the first driving signal, or drive the transistor to turn on under the second driving signal, and a reverse bias cut-off driving unit configured to drive the transistor unit to turn off in a case where voltage at two ends of the transistor unit is reversed.

## Description

### TECHNICAL FIELD

The present disclosure relates to the technical field of semiconductor circuit, in particular to an ideal diode circuit.

### BACKGROUND

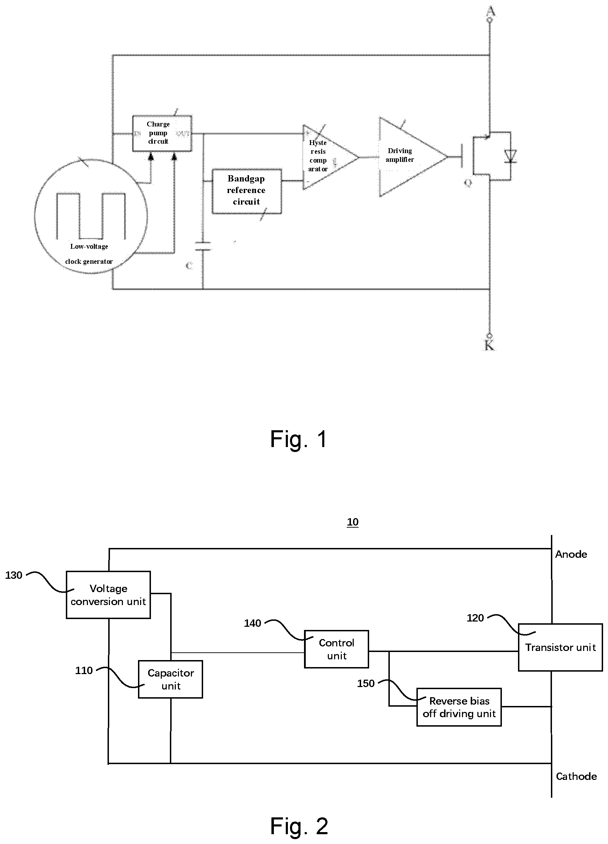

An ideal diode refers to a diode with a forward voltage drop of 0 and a reverse leakage current of 0. The conventional scheme of the ideal diode is shown in Fig.1. The determination of upper and lower limits of capacitor voltage is completed by reference + hysteresis comparator, which is a simple analog control mode, and the design of hysteresis comparator is also complicated. In addition, under high temperature and low current, the forward body diode voltage VF of MOSFET is small, and the charge pump pumping ability is weak, which can lead to the condition that the upper limit voltage VCAPH can not be pumped all the time, and the hysteresis comparator clock can not reach the flip condition, which leads to the ideal diode circuit unable to turn on MOSFET and unable to work normally and periodically.

For example, with setting VCAPL=5V and VCAPH=6V, the capacitor voltage VF is small under high temperature and small current, and the pumping ability of the charge pump circuit is weak, so that the upper limit of the output voltage only reaches 5.8V, which cannot reach the target upper limit voltage of the comparator of 6V. Meanwhile, the output of the hysteresis comparator is always low, and the MOSFET cannot be turned on, and the voltage drop across the MOSFET will always be high.

Therefore, an ideal diode circuit with high reliability is urgently needed.

### SUMMARY

In order to solve the above problems, the present disclosure provides the following technical scheme.

An ideal diode circuit comprises:
a capacitor unit and a transistor unit electrically connected thereto;
a voltage conversion unit electrically connected to the capacitor unit and the transistor unit respectively, and configured to charge the capacitor unit via a parasitic diode in the transistor unit;
a control unit, an input end of the control unit electrically connected to the capacitor unit and an output end of the control unit electrically connected to a control end of the transistor unit, wherein the control unit is configured to output a first driving signal or a second driving signal based on a voltage signal of the capacitor unit, drive the transistor unit to turn off under the first driving signal, and drive the transistor to turn on under the second driving signal;
a reverse bias cut-off driving unit, an input end of the reverse bias cut-off driving unit electrically connected to a first end of the capacitor unit, an output end of the reverse bias cut-off driving unit electrically connected to the control end of the transistor unit, and the reverse bias cut-off driving unit configured to drive the transistor unit to turn off under the first driving signal or in a case where the voltage at two ends of the transistor unit is reversed, and drive the transistor unit to turn on under the second driving signal.

In an optional embodiment of the present disclosure, the reverse bias cut-off driving unit comprises:
a reverse bias detection circuit, a first input end of the reverse bias detection circuit electrically connected to the control end of the transistor unit, a second input end of the reverse bias detection circuit electrically connected to a voltage measurement end of the transistor unit, and the reverse bias detection circuit configured to detect a voltage direction of the transistor unit;
a first turn-off circuit, an input end of the first turn-off device electrically connected to the output end of the reverse bias detection circuit, an output end of the reverse bias detection circuit electrically connected to the control end of the transistor unit, and the first turn-off device configured to drive the transistor unit to turn off in a case where the voltage at two ends of the transistor unit is reversed.

In an optional embodiment of the present disclosure, the ideal diode circuit further comprises:
a trigger circuit, a control end of the trigger circuit electrically connected to the first end of the capacitor unit, and an output end of the trigger circuit electrically connected to the input end of the reverse bias cut-off driving unit and the control end of the transistor unit respectively, and the trigger circuit configured to output the first driving signal or the second driving signal based on the voltage signal of the capacitor unit;
a driving circuit, an input end of the driving circuit electrically connected to the output end of the trigger circuit, the output end of the driving circuit electrically connected to the control end of the transistor unit, the driving circuit configured to drive the transistor unit to turn off under the first driving signal, and drive the transistor unit to turn on under the second driving signal.

In an optional embodiment of the present disclosure, the trigger circuit comprises:
a voltage comparison device, an input end of the voltage comparison device electrically connected to the first end of the capacitor unit, and the voltage comparison device configured to output a timing trigger signal in a case where the voltage signal of the capacitor unit is less than a preset reference voltage;
a timing trigger device, an input end of the timing trigger device electrically connected to the voltage comparison device, and an output end of the timing trigger device electrically connected to the input end of the driving circuit, and the timing trigger device configured to start timing under the timing trigger signal, output the first driving signal, and output the second driving signal after a preset periodical duration.

In an optional embodiment of the present disclosure, the timing trigger device is a constant turn-off time generator.

In an optional embodiment of the present disclosure, the voltage conversion unit comprises:
a charge pump, electrically connected to the capacitor unit and the transistor unit respectively;
a low-voltage clock, electrically connected to the charge pump and the capacitor unit respectively, and configured to drive the charge pump to operate in a case where the voltage signal of the capacitor unit is less than a preset reference voltage.

In an optional embodiment of the present disclosure, the transistor unit comprises a metal oxide semiconductor field effect transistor.

In an optional embodiment of the present disclosure, the ideal diode circuit further comprises:
a high-voltage isolation circuit, electrically connected to the capacitor unit, the transistor unit, and the voltage conversion unit, and configured to turn off the electrical connection between the transistor unit and the capacitor unit and/or the voltage conversion unit in a case where the voltage at two ends of the transistor unit is greater than a preset safe voltage.

In an optional embodiment of the present disclosure, the high-voltage isolation circuit comprises:
a voltage detection device, electrically connected to the transistor unit and configured to detect the voltage at two ends of the transistor unit;
a second turn-off device, electrically connected the transistor unit to the capacitor unit and/or the voltage conversion unit, and configured to turn off the electrical connection between the transistor unit and the capacitor unit and/or the voltage conversion unit in a case where the voltage at two ends of the transistor unit is greater than the preset safe voltage.

In an optional embodiment of the present disclosure, the transistor unit is an N-channel MOS field effect transistor.

In the ideal diode circuit provided by the embodiment of the present disclosure, an input end of the control unit is electrically connected to the capacitor unit and an output end of the control unit is electrically connected to a control end of the transistor unit, and the control unit is configured to output a first driving signal or a second driving signal based on a voltage signal of the capacitor unit, and to drive the transistor unit to turn off under the first driving signal, or drive the transistor to turn on under the second driving signal. Even under the case of high temperature and small current and the voltage drop at two ends of the capacitor unit not reach the set upper limit voltage, the control unit can control the conduction and closure of the transistor unit according to the preset period, and trigger to pump the capacitor unit after turning off the transistor unit MOSFET. In a case where the capacitor unit is charged for a fixed period, the transistor unit is turned on again without waiting for an accurate set voltage upper limit, thus realizing the operation requirements under extreme conditions and having higher reliability.

Also, in a case where the voltage at two ends of the transistor unit is reversed, the transistor unit is turned off based on the first turn-off device, so as to realize the protection of the transistor unit and the capacitor unit.

### BRIEF DESCRIPTION OF THE DRAWINGS

In order to more clearly explain the technical aspects of the embodiments or examples of the present disclosure, the drawings required to be used in the description of the embodiments or examples will be briefly described below. It will be apparent that the drawings described below are only some embodiments of the present disclosure, and therefore should not be regarded as limiting in scope. For those of ordinary skilled in the art, other drawings can be obtained according to those shown in these drawings without creative effort.
Fig. 1 is a circuit diagram of a conventional ideal diode circuit.
Fig. 2 is a circuit schematic diagram of an ideal diode circuit according to an embodiment of the present disclosure.
Fig. 3 is a circuit schematic diagram of an ideal diode circuit according to an embodiment of the present disclosure.
Fig. 4 is an operation waveform diagram of each device in the ideal diode circuit according to the embodiment of the present disclosure.

REFERENCES IN THE DRAWINGS: 10. ideal diode circuit; 110, capacitor unit; 120, transistor unit; 130, voltage conversion unit; 140, control unit; 150, reverse bias cut-off driving unit.

### DETAILED DESCRIPTION OF THE EMBODIMENTS

For the purposes, technical aspects and advantages of the embodiments of the present disclosure to be clearer, a clear and complete description of the technical aspects of the embodiments of the present disclosure will be given below in conjunction with the accompanying drawings in which it will be apparent that the described embodiments are part of, but not all of, the embodiments of the present disclosure, and the components of the embodiments of the present disclosure generally described and illustrated in the accompanying drawings herein can be arranged and designed in a variety of different configurations.

Accordingly, the following detailed description of the embodiments of the present disclosure provided in the accompanying drawings is not intended to limit the scope of the claimed disclosure, but only to represent selected embodiments of the present disclosure, based on which all other embodiments obtained without creative effort by a person having ordinary skill in the art fall within the scope of the disclosure.

The ideal diode refers to the diode with the forward voltage drop of 0 and the reverse leakage current of 0. The conventional scheme of ideal diode is shown in Fig.1. The determination of upper and lower limits of capacitor voltage is completed by reference + hysteresis comparator, which is a simple analog control mode, and the design of hysteresis comparator is also complicated. In addition, under high temperature and low current, the forward body diode voltage VF of MOSFET is small, and the charge pump pumping ability is weak, which can lead to the condition that the upper limit voltage VCAPH can not be pumped all the time, and the hysteresis comparator clock can not reach the flip condition, which leads to the ideal diode circuit unable to turn on MOSFET and unable to operate normally and periodically.

For example, with setting VCAPL=5V and VCAPH=6V, the capacitor voltage VF is small under high temperature and small current, and the pumping ability of the charge pump circuit is weak, so that the upper limit of the output voltage only reaches 5.8V, which cannot reach the target upper limit voltage of the comparator of 6V. Meanwhile, the output of the hysteresis comparator is always low, the MOSFET cannot be turned on, and the voltage drop at two ends of the MOSFET will always be high.

Therefore, an ideal diode circuit with high reliability is urgently needed.

Based on the above technical problems, with reference to Fig. 2, the embodiment of the present disclosure provides an ideal diode circuit 10 comprising a capacitor unit 110, a transistor unit 120, a voltage conversion unit 130, and a reverse bias cut-off driving unit 150, wherein:

The capacitor unit 110 and the transistor unit 120 in parallel with each other. The capacitor unit 110 refers to a device for storing electric charges and can comprise for example one capacitor unit 110 or a plurality of capacitor units 110 connected in series with each other. The transistor unit 120 comprises one or more transistors which is a device consisting of three layers of impurity semiconductors and having three electrodes, also called a semiconductor transistor, a triode transistor, or the like, can be a common transistor, a field effect transistor, a thyristor or the like, and is not specifically limited herein.

The voltage conversion unit 130 is electrically connected to the capacitor unit 110 and the transistor unit 120 respectively and configured to charge the capacitor unit 110 via a parasitic diode in the transistor unit 120. The voltage conversion unit 130 can be a transformer such as a capacity voltage converter or the like, via which the capacitor unit 110 is charged so that the voltage between two plates of the capacitor unit 110 is greater than the preset reference voltage.

The control unit 140, whose input end is electrically connected to the capacitor unit 110 and whose output end is electrically connected to the control end of the transistor unit 120, is configured to periodically output a first driving signal or a second driving signal based on a voltage signal of the capacitor unit 110 or according to an actual charging and discharging process of the capacitor unit 110, and to drive the transistor unit 120 to turn off under the first driving signal or to drive the transistor unit 120 to turn on under the second driving signal. The control unit 140 can be an integrated chip or a control circuit comprising different logic units. The embodiment of the present disclosure is not specifically limited and can be flexibly adjusted according to the actual situation. For example, the transistor inside the transistor unit 120 is an N-type transistor, the first driving signal can be a low-level signal, and the corresponding second driving signal can be a high-level signal, so that the transistor unit 120 can be turned off under the low-level signal and turned on under the high-level signal. Of course, this is only an example of the types of the first driving signal and the second driving signal which can be flexibly adjusted according to the types of the transistors in the transistor unit 120 and is not specifically limited here.

The input end of the reverse bias cut-off driving unit 150 is electrically connected to the first end of the capacitor unit 110. The output end of the reverse bias cut-off driving unit 150 is electrically connected to the control end of the transistor unit 120. The reverse bias cut-off driving unit 150 drives the transistor unit 120 to turn off in a case where the voltage at two ends of the transistor unit 120 is reversed.

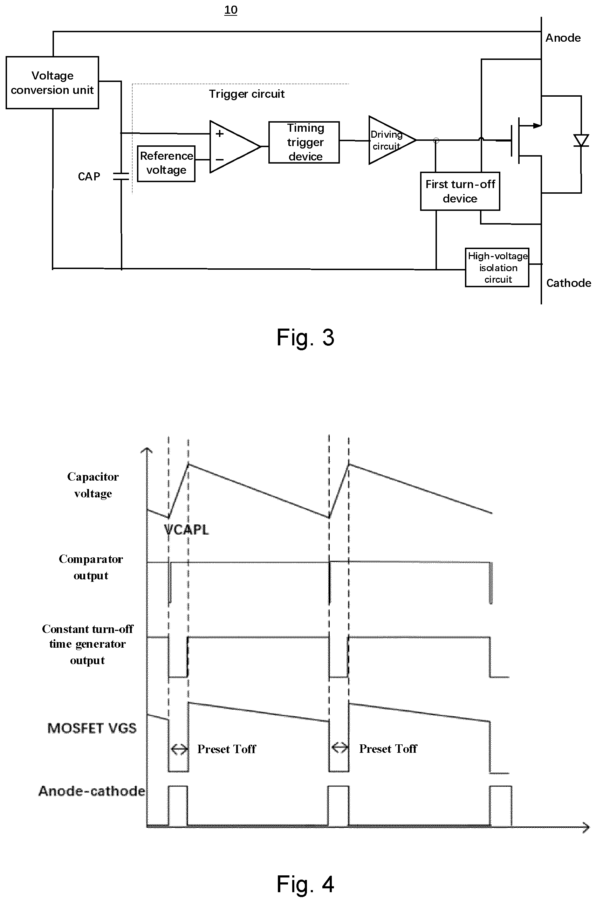

For example, in Fig. 3, normally, the current flow direction of the transistor unit 120 is from top to bottom, that is, the potential of the Anode end is higher than the potential of the Cathode end, but once the voltage is reversed, the potential of the Anode end is lower than the potential of the Cathode end, and it can be determined that the voltage at two ends of the transistor unit 120 is reversed. In this case, the transistor unit 120 can be turned off to protect the transistor unit 120.

The operation principle of the ideal diode provided by the embodiment of the disclosure is briefly introduced as follows:

With reference to Figs. 3 and 4, the control unit 140 periodically outputs the low-level signal or the high-level signal based on the voltage signal of the capacitor unit 110, drives the transistor unit 120 to turn off under the low-level signal, and drives the transistor unit 120 to turn on under the high-level signal. For example, in a case where the voltage signal at two ends of the capacitor unit 110 is less than the preset reference voltage, the control unit 140 outputs the low-level signal. Under the first driving signal, the transistor unit 120 is driven to turn off. Under the second driving signal, the transistor unit 120 is driven to turn on. The voltage drop at two ends of the transistor unit 120 (MOSFET) is reduced from VF to I*Ron about tens of mV, and the ideal diode function is realized.

With the voltage drop at two ends of the transistor unit 120 decreasing and the voltage at two ends of the capacitor unit 110 (CAP) is consumed to a preset reference voltage (i.e., the lower limit value VCAPL), the control unit 140 outputs the first driving signal (e.g., the low-level signal) again, drives the transistor unit 120 (MOSFET) to turn off under the low-level signal, and the voltage conversion unit 130 starts to operate and re-enters the period for charging the capacitor unit 110. After timing for a preset periodical duration Toff, the transistor unit 120 (MOSFET) is turned on again, to be cyclically and periodically operated.

In the ideal diode circuit 10 provided by the embodiment of the present disclosure, the input end of the control unit 140 is electrically connected to the capacitor unit 110 and the output end of the control unit 140 is electrically connected to the control end of the transistor unit 120, and the control unit 140 is configured to output the first driving signal or the second driving signal based on the voltage signal of the capacitor unit, and to drive the transistor unit 120 to turn off under the first driving signal, or drive the transistor unit 120 to turn on under the second driving signal. Even under the condition of high temperature and small current and the voltage drop at two ends of the capacitor unit 110 does not reach the set upper limit voltage, the control unit 140 can periodically control the conduction and closure of the transistor unit 120 according to the preset period, and trigger to pump the capacitor unit 110 after turning off the transistor unit 120 (MOSFET). In a case where the capacitor unit 110 is charged for a fixed period, to turn on again without waiting for an accurate set voltage upper limit, thus realizing the operation requirements under extreme conditions and having higher reliability.

Also, in a case where the voltage at two ends of the transistor unit 120 is reversed, the transistor unit 120 is turned off based on the first turn-off device, so as to realize the protection of the transistor unit 120 and the capacitor unit 110.

Further, with reference to Fig. 3, in an optional embodiment of the present disclosure, the reverse bias cut-off driving unit 150 comprises:
a reverse bias detection circuit, a first input end of the reverse bias detection circuit electrically connected to the control end of the transistor unit 120, a second input end of the reverse bias detection circuit electrically connected to a voltage measurement end of the transistor unit 120, and the reverse bias detection circuit configured to detect a voltage direction of the transistor unit 120;
a first turn-off circuit, an input end of the first turn-off device electrically connected to the output end of the reverse bias detection circuit, an output end of the reverse bias detection circuit electrically connected to the control end of the transistor unit 120, and the first turn-off device configured to drive the transistor unit 120 to turn off in a case where voltage at two ends of the transistor unit 120 is reversed.

The embodiment of the present disclosure detects the voltage direction of the transistor unit 120 based on the reverse bias detection circuit, and then turns off the transistor unit 120 based on the first turn-off device in a case where the voltage at two ends of the transistor unit 120 is reversed, so as to realize the protection of the transistor unit 120 and the capacitor unit 110.

Further, with reference to Fig. 3, in an optional embodiment of the present disclosure, the control unit 140 comprises a trigger circuit and a drive circuit, wherein:
The control end of the trigger circuit electrically connected to the first end of the capacitor unit 110, and an output end of trigger circuit electrically connected to the input end of the reverse bias cut-off driving unit 150 and the control end of the transistor unit 120 respectively, and the trigger circuit configured to periodically output the first driving signal (e.g. the low-level signal) or the second driving signal (e.g. the high-level signal) based on the voltage signal of the capacitor unit 110.

The trigger circuit is configured to trigger the driving circuit to start operating. The trigger signal of the trigger circuit is the voltage drop of the voltage signal at two ends of the capacitor unit 110. For example, if the voltage drop is greater than or equal to the preset reference voltage, the high-level signal is output, and if the voltage drop is less than the preset reference voltage, the low-level signal is output. Of course, this is only an example and does not constitute a specific limitation on the operation mode of the control unit 140 according to the embodiment of the present disclosure.

The input end of the driving circuit is electrically connected to the output end of the trigger circuit, and the output end of the driving circuit is electrically connected to the control end of the transistor unit 120. The driving circuit drives the transistor unit 120 to turn off under the first driving signal (e.g. the low-level signal) and drives the transistor unit 120 to turn on under the second driving signal (e.g. the high-level signal). The driving circuit can be an integrated chip or a preset electronic circuit. The embodiment of the present disclosure is not specifically limited and can be flexibly adjusted according to the actual situation. It only needs to realize the function of driving the transistor unit 120 to turn off based on the high-level signal and driving the transistor unit 120 to turn on under the high-level signal.

The trigger circuit of the embodiment of the present disclosure periodically outputs the low-level signal or the high-level signal based on the voltage signal of the capacitor unit 110, and the driving circuit drives the transistor unit 120 to turn off under the low-level signal, and drives the transistor unit 120 to turn on under the high-level signal, thus separating the generation the level signal from the driving the transistor unit 120, having independent functions and no influence on each other, and having higher reliability.

Further, with reference to Fig. 3, in an optional embodiment of the present disclosure, the trigger circuit comprises a voltage comparison device and a timing trigger device, wherein:
The input end of the voltage comparison device is electrically connected to the first end of the capacitor unit 110, and the voltage comparison device is configured to output a timing trigger signal in a case where the voltage signal of the capacitor unit 110 is less than a preset reference voltage. The voltage comparison device is configured to compare the voltage at two ends of the capacitor unit 110 with the preset reference voltage which can be set according to the actual situation, such as the lower limit voltage VCAPL of the capacitor unit 110, etc, which is not specifically limited here, and can be flexibly adjusted according to the actual situation. The voltage comparison device can be a common comparator, rather than the traditional hysteresis comparator. Compared with the hysteresis comparator, the design of the common comparator is simpler and the cost is lower.

The input end of the timing trigger device is electrically connected to the voltage comparison device, and an output end of the timing trigger device is electrically connected to the input end of the driving circuit. The timing trigger device is configured to start timing under the timing trigger signal, output the low-level signal, and output the high-level signal after the preset periodical duration.

The timing trigger device comprises at least two functional modules: a timing function module and a level signal generation module. The timing function module is configured to determine the signal generation period, i.e. generate the low-level signal via the level generation module from the starting time to the preset period time, and generate the high-level signal via the level signal generation module in the preset periodical duration Toff.

In an optional embodiment of the present disclosure, the timing trigger device is a constant turn-off time generator, which is also called a constant turn-off time controller. The constant turn-off time generator is an electronic device that turns off in a fixed duration, and the fixed duration is the above preset periodical duration. The low-level signal is output in the periodical duration, the high-level signal is output after the periodical duration. The time starts timing again after receiving the next timing trigger signal (i.e., the trigger signal output in a case where the voltage signal at two ends of the capacitor unit 110 is less than the preset reference voltage). The constant turn-off time generator has the advantages of simple structure, lower cost, and higher reliability. The ideal diode in the embodiment of the disclosure is realized based on the constant turn-off time generator and other unit devices, which has higher reliability and lower cost.

Further, with reference to Fig. 3, in an optional embodiment of the present disclosure, the voltage conversion unit 130 comprises a charge pump and a low-voltage clock, wherein:
The charge pump is electrically connected to the capacitor unit 110 and the transistor unit 120 respectively.

The low-voltage clock is electrically connected to the charge pump and the capacitor unit 110 respectively, and the low-voltage clock is configured to drive the charge pump to operate in a case where the voltage signal of the capacitor unit 110 is less than a preset reference voltage. The low-voltage clock generates a pulse signal or a digital signal, and the charge pump is driven by the pulse signal or the digital signal. The trigger signal of the low-voltage clock is the case of the voltage signal of the capacitor unit 110 smaller than the preset reference voltage.

The embodiment of the present disclosure realizes the charging of the capacitor unit 110 via the charge pump and the low-voltage clock. The charge pump has a strong pumping ability and can fill the electric quantity of the capacitor unit 110 in a short time, thus improving the operation efficiency of the ideal diode provided by the embodiment of the present disclosure.

In an optional embodiment of the present disclosure, the transistor unit 120 comprises a Metal-Oxide-Semiconductor Field-Effect Transistor (MOSFET), which is a voltage control component and a field-effect transistor controlling semiconductor (s) with the gate of a metal layer (m) across an oxide layer (o) by the effect of an electric field. The MOSFET has the advantages of high input impedance, low noise, good thermal stability, strong radiation resistance, and the like, as well as the advantages of small size, light weight, and the like. The embodiment of the disclosure provides the ideal diode in the embodiment of the disclosure based on the metal oxide semiconductor field effect transistor and other unit devices, having higher reliability and lower cost.

Further, with reference to Fig. 3, in an optional embodiment of the present disclosure, the ideal diode circuit 10 further comprises a high-voltage isolation circuit.

The high-voltage isolation circuit is electrically connected to the capacitor unit 110, the transistor unit 120, and the voltage conversion unit 130, and configured to turn off the electrical connection between the transistor unit 120 and the capacitor unit 110 and/or the voltage conversion unit 130 in a case where the voltage at two ends of the transistor unit 120 is greater than the preset safe voltage.

In an optional embodiment of the present disclosure, the high-voltage isolation circuit comprises a voltage detection device and a second turn-off device, wherein:
The voltage detection device is electrically connected to the transistor unit 120 and configured to detect the voltage at two ends of the transistor unit 120.

The second turn-off device is electrically connected the transistor unit 120 to the capacitor unit 110 and/or the voltage conversion unit 130, and configured to turn off the electrical connection between the transistor unit 120 and the capacitor unit 110 and/or the voltage conversion unit 130 in a case where the voltage at two ends of the transistor unit 120 is greater than the preset safe voltage.

Once the voltage detection device detects that the voltage at two ends of the transistor unit 120 exceeds the preset safe voltage, the electrical connection between the transistor unit 120 and the capacitor unit 110 and/or the voltage conversion unit 130 can be immediately turned off by the second turn-off device, so as to realize the protection of the capacitor unit 110 and the voltage conversion unit 130 and improve the safety and reliability of the ideal diode.

In an optional embodiment of the present disclosure, the capacitor unit 110 comprises one or more capacitors, and the energy storage capacity is improved by connecting multiple capacitors in parallel or increasing the capacity of one single capacitor, thereby improving the operating performance of the ideal diode.

In an optional embodiment of the present disclosure, the transistor unit 120 is an N-channel MOS field effect transistor, which can support high-voltage driving, that is, the control of the high-level signal output by the capacitor unit 110 of the embodiment of the present disclosure, thereby improving the reliability and stability of the ideal diode circuit of the embodiment of the present disclosure.

The operation principle of the ideal diode provided by the above embodiment of the disclosure is briefly introduced as follows:
Further, with reference to Figs. 2-4, the voltage comparison device compares the voltage at two ends of the capacitor unit 110 (CAP) with the preset reference voltage. In a case where the voltage signal at two ends of the capacitor unit 110 is less than the preset reference voltage, the voltage comparator outputs the timing trigger signal, which can be a low-level signal. The constant turn-off time generator starts immediately after receiving the timing trigger signal, starts timing, and outputs a low-level signal, and the driving circuit drives the transistor unit 120 (MOSFET) to turn off under the low-level signal. The constant turn-off time generator outputs the high-level signal after the preset periodical duration Toff from the start of timing, drives the transistor unit 120 to turn on under the high-level signal, and reduces the voltage drop at two ends of the transistor unit 120 (MOSFET) from VF to I*Ron about tens of mV, thus realizing the ideal diode function.

With the voltage drop at two ends of the transistor unit 120 decreasing and the voltage at two ends of the capacitor unit 110 (CAP) consumed to the preset reference voltage (i.e., the lower limit value VCAPL), the voltage comparison device detects the voltage signal at two ends of the capacitor unit 110 less than the preset reference voltage and outputs a timing trigger signal. The constant turn-off time generator starts immediately after receiving the timing trigger signal, starts timing, and outputs a low-level signal. The driving circuit drives the transistor unit 120 (MOSFET) to turn off under the low-level signal, and the low-voltage clock drives the charge pump to start operating and re-enters the period for charging the capacitor unit 110. After timing for a preset periodical duration Toff, the transistor unit 120 (MOSFET) is turned on again, to be cyclically and periodically operated.

It should be mentioned that, in a case where the voltage of the capacitor unit 110 is less than the preset lower limit (VCAPL), the constant turn-off time generator is triggered to start timing, the high-level signal is output after the preset periodical duration Toff, and the transistor unit 120 is driven to turn on under the high-level signal. The constant turn-off time generator continuously outputs a level signal within the preset periodical duration Toff, and outputs a high-level signal outside the preset periodical duration Toff to control the transistor unit 120 (MOSFET) to turn on, so as to discharge the energy storage capacitor.

The above embodiments are expressed only as preferred embodiments of the present disclosure and the description thereof is more specific and detailed but is not therefore to be construed as limiting the scope of the present disclosure. It should be noted that a number of modifications, improvements, and substitutions can be made to one having ordinary skill in the art without departing from the concept of the present disclosure, which fall within the scope of the present disclosure.

## Claims

1. An ideal diode circuit, comprising:
a capacitor unit and a transistor unit electrically connected thereto;
a voltage conversion unit electrically connected to the capacitor unit and the transistor unit respectively, and configured to charge the capacitor unit via a parasitic diode in the transistor unit;
a control unit, an input end of the control unit electrically connected to the capacitor unit, and an output end of the control unit electrically connected to a control end of the transistor unit, wherein the control unit is configured to output a first driving signal or a second driving signal based on a voltage signal of the capacitor unit, drive the transistor unit to turn off under the first driving signal, and drive the transistor to turn on under the second driving signal; and
a reverse bias cut-off driving unit, an input end of the reverse bias cut-off driving unit electrically connected to a first end of the capacitor unit, an output end of the reverse bias cut-off driving unit electrically connected to the control end of the transistor unit, and the reverse bias cut-off driving unit configured to drive the transistor unit to turn off in a case where voltage at two ends of the transistor unit is reversed.

2. The ideal diode circuit according to claim 1, wherein the reverse bias cut-off driving unit comprises:
a reverse bias detection circuit, a first input end of the reverse bias detection circuit electrically connected to the control end of the transistor unit, a second input end of the reverse bias detection circuit electrically connected to a voltage measurement end of the transistor unit, and the reverse bias detection circuit configured to detect a voltage direction of the transistor unit; and
a first turn-off circuit, an input end of the first turn-off device electrically connected to the output end of the reverse bias detection circuit, an output end of the reverse bias detection circuit electrically connected to the control end of the transistor unit, and the first turn-off device configured to drive the transistor unit to turn off in a case where voltage at two ends of the transistor unit is reversed.

3. The ideal diode circuit according to claim 1, wherein the control unit comprises:
a trigger circuit, a control end of the trigger circuit electrically connected to the first end of the capacitor unit, and an output end of trigger circuit electrically connected to the input end of the reverse bias cut-off driving unit and the control end of the transistor unit respectively, and the trigger circuit configured to output the first driving signal or the second driving signal based on the voltage signal of the capacitor unit; and
a driving circuit, an input end of the driving circuit electrically connected to the output end of the trigger circuit, an output end of the driving circuit electrically connected to the control end of the transistor unit, and the driving circuit configured to drive the transistor unit to turn off under the first driving signal, and drive the transistor unit to turn on under the second driving signal.

4. The ideal diode circuit according to claim 3, wherein the trigger circuit comprises:
a voltage comparison device, an input end of the voltage comparison device electrically connected to the first end of the capacitor unit, and the voltage comparison device configured to output a timing trigger signal in a case where the voltage signal of the capacitor unit is less than a preset reference voltage; and
a timing trigger device, an input end of the timing trigger device electrically connected to the voltage comparison device, an output end of the timing trigger device electrically connected to the input end of the driving circuit, and the timing trigger device configured to start timing under the timing trigger signal, output the first driving signal, and output the second driving signal after a preset periodical duration.

5. The ideal diode circuit according to claim 4, wherein the timing trigger device is a constant turn-off time generator.

6. The ideal diode circuit according to any one of claims 1 to 5, wherein the voltage conversion unit comprises:
a charge pump, electrically connected to the capacitor unit and the transistor unit respectively; and
a low-voltage clock, electrically connected to the charge pump and the capacitor unit respectively, and the low-voltage clock configured to drive the charge pump to operate in a case where the voltage signal of the capacitor unit is less than a preset reference voltage.

7. The ideal diode circuit according to any one of claims 1 to 6, wherein the transistor unit comprises: a metal oxide semiconductor field effect transistor.

8. The ideal diode circuit according to any one of claims 1 to 7, further comprising:
a high-voltage isolation circuit electrically connected to the capacitor unit, the transistor unit, and the voltage conversion unit, and configured to turn off the electrical connection between the transistor unit and the capacitor unit and/or the voltage conversion unit in a case where the voltage at two ends of the transistor unit is greater than a preset safe voltage.

9. The ideal diode circuit according to claim 8, wherein the high-voltage isolation circuit comprises:
a voltage detection device, electrically connected to the transistor unit and configured to detect the voltage at two ends of the transistor unit; and
a second turn-off device, electrically connected the transistor unit to the capacitor unit and the voltage conversion unit, and configured to turn off the electrical connection between the transistor unit and the capacitor unit and/or the voltage conversion unit in a case where the voltage at two ends of the transistor unit is greater than a preset safe voltage.

10. The ideal diode circuit according to claim 7, wherein the transistor unit is an N-channel MOS field effect transistor.
